Europäisches Patentamt

European Patent Office

Office européen des brevets

(19)

(11) Veröffentlichungsnummer: **0 477 429 A1**

## (12) EUROPÄISCHE PATENTANMELDUNG

(21) Anmeldenummer: **90118728.6**

(22) Anmeldetag: **28.09.90**

(51) Int. Cl.⁵: **H01L 27/02**

(43) Veröffentlichungstag der Anmeldung:
**01.04.92 Patentblatt 92/14**

(84) Benannte Vertragsstaaten:
**AT BE CH DE DK ES FR GB GR IT LI LU NL SE**

(71) Anmelder: **SIEMENS AKTIENGESELLSCHAFT**
**Wittelsbacherplatz 2**
**W-8000 München 2(DE)**

(72) Erfinder: **Becker, Burkhard, Dr. rer. nat.**
**Schlüsselbergstrasse 8**
**W-8000 München 80(DE)**

(54) **Eingangsschutzstruktur für integrierte Schaltungen.**

(57) Eine Eingangsschutzstruktur für integrierte Schaltungen, die in einem Halbleitersubstrat zwischen einen Eingang (1) und einen Ausgang (2) geschaltet ist, die einen Eingangstransistor (3) und einen Ansteuertransistor (4) enthält, und die eine Oxid-Isolation benachbarter Bauelemente aufweist, soll einen schnellen und zuverlässigen Schutz gegen elektrostatische Entladungen beider Polaritäten gewährleisten. Der Eingangstransistor (3) und der Ansteuertransistor (4) sind in Kaskade geschaltet, der gemeinsame Kollektor von Eingangstransistor (3) und Ausgangstransistor (4) bildet den Eingang (1) der Schutzstruktur, und der Emitter des Eingangstransistors (3) ist mit dem Ausgang (2) für das Bezugspotential verbunden.

FIG 1

EP 0 477 429 A1

Die Erfindung betrifft eine Eingangsschutzstruktur für integrierte Schaltungen nach dem Oberbegriff des Anspruchs 1.

Integrierte Schaltungen benötigen einen sicheren Schutz gegen elektrostatische Entladungen (ESD-Schutz). Zu diesem Zweck werden sie mit Eingangsschutzstrukturen versehen. Derartige Eingangsschutzstrukturen, die zwei miteinander verschaltete Transistoren enthalten, sind bekannt und beispielsweise in der DE-OS 36 16 394 beschrieben. Allerdings werden solche Eingangsschutzstrukturen bisher nur bei bipolaren integrierten Schaltungen verwendet, bei denen benachbarte Bauelemente durch eine PN-Isolation voneinander isoliert sind.

Der Erfindung liegt die Aufgabe zugrunde, eine Eingangsschutzstruktur für bipolare integrierte Schaltungen, die mit einer Oxid-Isolation benachbarter Bauelemente versehen sind, zu schaffen, die einen schnellen und zuverlässigen Schutz gegen elektrostatische Entladungen beider Polaritäten gewährleistet.

Diese Aufgabe wird erfindungsgemäß durch eine Eingangsschutzstruktur mit den Merkmalen des Anspruchs 1 gelöst.

Vorteilhafte Ausgestaltungen bzw. Weiterbildungen der Erfindung sind Gegenstand zusätzlicher Ansprüche.

Anhand von in den Figuren der Zeichnung dargestellten Ausführungsbeispielen wird die Erfindung im folgenden näher erläutert. Es zeigen

FIG 1     ein Ersatzschaltbild einer Eingangsschutzstruktur,

FIG 2     ein Ersatzschaltbild einer weiteren Eingangsschutzstruktur,

FIG 3     eine schematische Darstellung der Eingangsschutzstruktur     nach FIG 1 und

FIG 4     eine schematische Darstellung der Eingangsschutzstruktur nach FIG 2.

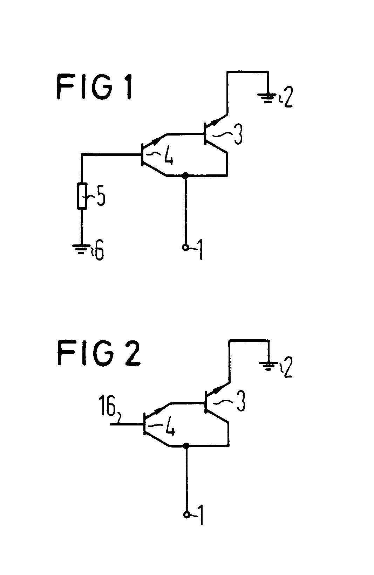

Gemäß FIG 1 und FIG 2 liegt zwischen einem Eingangsanschluß 1 einer integrierten Schaltung und einem Ausgang 2 für ein Bezugspotential, insbesondere Erdpotential, eine Schutzstruktur, die aus einem ersten Transistor als Eingangstransistor 3 und einem zweiten Transistor als Ansteuertransistor 4 gebildet ist. Der Eingangstransistor 3 und der Ansteuertransistor 4 sind in Kaskade geschaltet. Eine solche Schaltung von zwei npn-Transistoren ist an sich bekannt, und zwar als Verstärkerschaltung unter der Be zeichnung Darlington-Schaltung. Der gemeinsame Kollektor des Eingangstransistors 3 und des Ansteuertransistors 4 bildet den Eingang 1 der Schutzstruktur, der parallel zu einem zu schützenden Bauelement geschaltet wird. Der Emitter des Eingangstransistors 3 ist mit dem Anschluß 2 für ein Bezugspotential verbunden; zweckmäßig wird dieser mit Erdpotential bzw. Masse beaufschlagt. In dem Beispiel gemäß FIG 1 ist die Basis des Ansteuertransistors 4 über einen integrierten Widerstand 5 mit dem Erdpotential verbunden bzw. auf Masse 6 gelegt.

In dem Beispiel gemäß FIG 2 ist die Basis des Ansteuertransistors 4 erd- bzw. potentialfrei als sogenannte floatende bzw. offene Basis 16 ausgebildet.

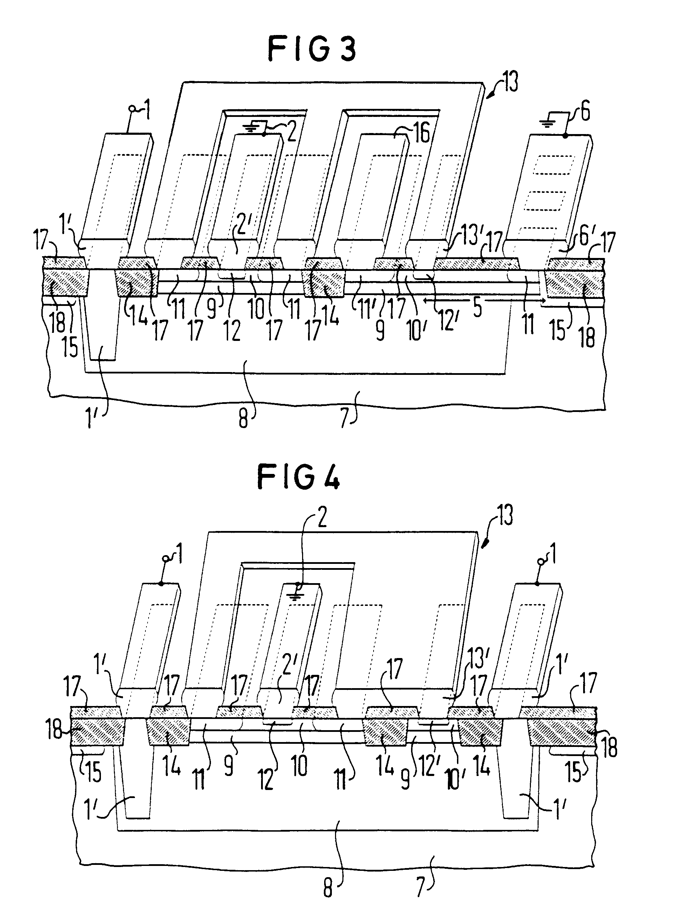

Die in den Figuren 3 und 4 dargestellten und anhand der Ersatzschaltbilder der Fig 1 und FIG 2 erläuterten Eingangsschutzstrukturen werden in einem Halbleitersubstrat 7, zweckmäßig einem p-leitenden Halbleitersubstrat, in mehreren an sich bekannten Verfahrensschritten erzeugt. Beide Strukturen sind bis auf den integrierten Substrat-Kontakt 6 (Massekontakt) der Struktur der FIG 3 vollständig mit einer hochdotierten, n-leitenden vergrabenen Schicht, einer sogenannten Buried-Layer 8 unterlegt. Beide Strukturen werden von der Oxid-Isolation 18 für benachbarte Bauelemente begrenzt, die mit einer hochdotierten p-leitenden Zone, einem sogenannten Channelstopper 15 unterlegt sein kann. Ein (FIG 3) bzw. zwei (FIG 4) Kollektor-Tief-Diffusions-Anschlüsse 1' bilden den Eingang 1 der jeweiligen Struktur, d.h. sie werden parallel zu dem zu schützenden Bauelement geschaltet. Bei dem in FIG 4 dargestellten Ausführungsbeispiel kann man auch mit nur einem Kollektor-Tief-Diffusions-Anschluß auskommen. Die Verwendung von zwei Anschlüssen 1' für den Eingang 1 stellt eine insbesondere aus Symmetriegründen vorteilhafte Ausführungsform der Schutzstruktur dar.

Die Eingangstransistoren 3 (FIG 1 und FIG 2) beider in den FIG 3 und FIG 4 dargestellten Schutzstrukturen besitzen den gleichen Aufbau: $n^+$-Kollektor-Tief-Diffusions-Anschluß 1', $n^+$-Buried-Layer 8, n-Epitaxiegebiet 9, p-Basis-Diffusionszone 10 mit $p^+$-Basis-Kontakt-Gebieten 11 sowie der $n^+$-Emitter-Diffusionszone 12. Der Aufbau der Eingangstransistoren entspricht damit dem eines Standard-npn-Transistors einer verwendeten entsprechenden Prozeßlinie.

Eine metallische Verbindung 13 kontaktiert sowohl die Basis-Kontakt-Gebiete 11 des Eingangstransistors 3 als auch die in einem Basisgebiet 10' (Basis des Ansteuertransistors 4) liegende Emitter-Diffusionszone 12' des Ansteuertransistors 4 (FIG 1, 2). Die Basis-Kontakt-Gebiete 11' sowie deren Metall-Kontakt 16 im Basis-Emitter-Bereich des Ansteuertransistors sorgen für eine Homogenisierung des Feldstärke- bzw. Stromverlaufs und damit für eine erhöhte ESD-Belastbarkeit. Die Basis-Emitter-Bereiche des Ansteuer- bzw. des Eingangstransistors sind durch eine auf der gemeinsamen Buried-Layer 8 aufliegende Oxid-Isolation 14 voneinander getrennt.

Der integrierte Widerstand 5 gemäß FIG 1 wird bei der in FIG 3 dargestellten Schutzstruktur durch die Basis-Diffusions-Zone 10' des Ansteuertransistors 4, welche diffusionsmäßig mit dem Substrat 7 verbunden ist, gebildet. Ein integrierter Substrat-Anschluß (Masse-Anschluß 6) , gebildet aus Basis-Kontakt-Diffusionsgebiet 11, Channel-Stopper 15, Metallkontakt 6', soll mit dem Masse-Anschluß eines zu schützenden Schaltkreises verbunden werden.

Auf die Oberfläche der beiden in den FIG 3 und FIG 4 dargestellten Halbleitersysteme ist eine isolierende Schicht 17 aufgebracht, die zur Herstellung von Anschlußöffnungen für die Eingangsanschlüsse 1', die Ausgangsanschlüsse 2', die metallische Verbindung 13, 13' den Substrat- bzw. Masse-Anschluß 6,6' (FIG 1 und FIG 3) und den offenen Basis-Anschluß 16 (FIG 3) strukturiert ist.

Der mit der erfindungsgemäßen Eingangsschutzstruktur bewirkte ESD-Schutz wird wie folgt erreicht.

a) Für negative Impulse: Die Ableitung des Impulses erfolgt über den Buried-Layer-Substrat-Übergang sowie im Fall der FIG 1 über den Kollektor-Basis-Übergang des Ansteuertransistors 4 sowie über den integrierten Widerstand 5 nach Masse 6. In diesem Fall sorgt das Vorhandensein zweier Ableitpfade für eine homogene Stromverteilung über der Fläche des Bauelements.

Die Struktur gemäß FIG 2 und FIG 4 gleicht aufgrund des kompakteren Aufbaus das Fehlen eines zweiten Ableitpfades (Kollektor-Basis-Strecke des Ansteuertransistors 4) aus.

In beiden Fällen wird eine Zerstörung der empfindlichen, in Sperrichtung gepolten Emitter-Basis-Strecken durch die homogene Strom- bzw. Feldstärkeverteilung weitgehend verhindert.

b) Für positive Impulse: Die Ableitung des Impulses erfolgt durch einen Durchbruch der Kollektor-Emitter-Strecke des Eingangstransistors 3, welcher durch einen U(CER)- bzw. U-(CEO)-Durchbruch des Ansteuertransistors 4 kontrolliert wird.

Der Ansteuertransistor 4 versorgt die Basis des Eingangstransistors 3 im Fall des U(CEO)- bzw. U(CER)-Durchbruchs mit einem Basisstrom, womit die normale Transistor-Arbeitsweise aufgenommen wird. Der Eingangstransistor leitet somit den Impuls nach Masse ab. Die Ansprechschnelligkeit sowie die Stromtragfähigkeit der Transistorschaltung gewährleistet den Schutz parallel liegender Bauelemente. Der Schutz des Eingangstransistors selbst wird durch die Transistor-Wirkung mit angesteuerter Basis gewährleistet. Einer Zerstörung des Ansteuertransistors wird durch die Reihenschaltung der Dioden-Strecken (Kollektor-Basis sowie Basis-Emitter des Ansteuertransistors sowie Basis-Emitter des Eingangstransistors) entgegengewirkt. Gegenüber einer einfachen Diodenstrecke wird hier eine Strombegrenzung erreicht.

Im Fall der FIG 1 bzw.FIG 3 sorgt der Durchbruch der Kollektor-Basis-Sperrschichtdes Ansteuertransitors über den integrierten Widerstand 5 sowohl für eine Homogenisierung des Stromverlaufs als auch für eine Aufteilung der Ableitung des Impulses auf mehrere Pfade.

Signalspannungen können bis zur U(CEO)-Grenze der betreffenden Prozeßlinie verarbeitet werden. Aufgrund einer Verkleinerung des Abstandes zwischen Emitter- und Basis-Kontakt-Diffusion des Ansteuertransistors kann die Durchbruchsspannung der Struktur bis zur U(CER)-Grenze angehoben werden.

**Patentansprüche**

1. Eingangsschutzstruktur für integrierte Schaltungen, die in einem Halbleitersubstrat zwischen einen Eingang und einen Ausgang für ein Bezugspotential geschaltet ist, die einen ersten Transistor als Eingangstransistor und einen zweiten Transistor als Ansteuertransistor enthält, und die eine Oxid-Isolation benachbarter Bauelemente aufweist, **dadurch gekennzeichnet,** daß der Eingangstransistor (3) und der Ansteuertransistor (4) in Kaskade geschaltet sind, daß der gemeinsame Kollektor von Eingangstransistor (3) und Ansteuertransistor (4) den Eingang (1) der Schutzstruktur bildet, und daß der Emitter des Eingangstransistors (3) mit dem Ausgang (2) für das Bezugspotential verbunden ist.

2. Eingangsschutzstruktur nach Anspruch 1, **dadurch gekennzeichnet,** daß die Basis des Ansteuertransistors (4) eine potentialfreie Basis ist.

3. Eingangsschutzstruktur nach Anspruch 1, **dadurch gekennzeichnet,** daß die Basis des Ansteuertransistors (4) über einen integrierten Widerstand (5) mit Masse (6) verbunden ist.

FIG 1

FIG 2

# FIG 3

# FIG 4

# EUROPÄISCHER RECHERCHENBERICHT

Nummer der Anmeldung

**EP 90 11 8728**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | GB-A-2 019 645 (SGS-ATES COMPONENTI)<br>* Seite 2, Zeile 36 - Seite 3, Zeile 77; Figuren *<br>— — — | 1-3 | H 01 L 27/02 |
| D,A | GB-A-2 176 053 (SGS MICROELETTRONICA)<br>* Zusammenfassung; Figuren & DE-A-3616394 *<br>— — — — — | 1-3 | |
| | | | **RECHERCHIERTE SACHGEBIETE (Int. Cl.5)**<br><br>H 01 L |

Der vorliegende Recherchenbericht wurde für alle Patentansprüche erstellt

| Recherchenort | Abschlußdatum der Recherche | Prüfer |
|---|---|---|
| Den Haag | 15 Mai 91 | VENDANGE P. |